# EUROPEAN PATENT APPLICATION

(11) **EP 2 570 877 A1**
(43) Date of publication of application: **20.03.2013**
(21) Application number: 12183779.3
(22) Date of filing: 10.09.2012
(51) Int. Cl.: G05B 17/02, G05B 13/04

(54) **System and method for simulating gas turbine operation**

(30) Priority: 14.09.2011 US 201113232279
(71) Applicant: General Electric Company, Schenectady, NY 12345 (US)
(72) Inventor: Morgan, Rex Allen, Greenville, SC 29615 (US); MIitchell, Paul Jeffrey, Greenville, SC 29615 (US)
(74) Representative: Cleary, Fidelma

(57) **Abstract**

A method for simulating a gas turbine is disclosed. The method may generally include sensing values of a plurality of first operating parameters of a gas turbine, applying the first operating parameters to a model (48) of the gas turbine to generate a plurality of predicted operating parameters, determining difference values between the predicted operating parameters and a corresponding plurality of sensed second operating parameters of the gas turbine, applying an error correction system (58) to the difference values to determine correction factors (68) and adjusting the model (48) of the gas turbine (12) using the correction factors (68), wherein the predicted operating parameters include at least one predicted combustion product parameter and the sensed second operating parameters include at least one sensed combustion product parameter.

## Description

### FIELD OF THE INVENTION

The present subject matter relates generally to control systems for gas turbines and, more particularly, to a system and method for using combustion product parameters and other operating parameters of a gas turbine, applied through a Kalman filter, to tune an electronic, mathematical model of the gas turbine.

### BACKGROUND OF THE INVENTION

Industrial and power generation gas turbines have control systems ("controllers") that monitor and control their operation. These controllers govern the combustion system of the gas turbine and other operational aspects of the gas turbine. Typically, the controller executes scheduling algorithms that adjust the fuel flow, angle of the inlet guide vanes (IGV) and other control inputs to ensure safe and efficient operation of the gas turbine.

Gas turbine controllers typically receive input values of measured operating parameters and desired operating settings (e.g., power output, exhaust energy and the like) that, in conjunction with scheduling algorithms, determine settings for control parameters (e.g., fuel flow, combustor fuel splits, IGV angle, inlet bleed heat flow and the like) to achieve desired operation of the gas turbine. It is generally presumed that the values prescribed by the scheduling algorithms for the control parameters will cause the gas turbine to operate at a desired state, such as at a desired power output level and within defined emission limits. Thus, the scheduling algorithms incorporate assumptions regarding the gas turbine, such as that it is operating at a certain efficiency, with a certain flow capacity and at other assumed conditions. However, as the gas turbine operates for an extended period, component efficiencies tend to degrade and flow capacities and other operating conditions vary from the assumed conditions. Because of this deterioration, the scheduling algorithms become increasingly out of tune and cause the gas turbine to operate at states that increasingly diverge from the desired operational state.

To correct for changes in efficiency, flow capacity and other operating conditions, a gas turbine must be periodically "tuned." Typically, this entails an engineer or technician manually adjusting the gas turbine, which requires that the gas turbine be taken off-line to be instrumented for tuning. To prevent the downtime required for manual tuning, U.S. Patent No. 7,742,904 (assigned to the General Electric Company) discloses a system and method that automatically adjusts the mathematical model for a gas turbine to account for changes (e.g., changes in component efficiencies and flow capacities) that occur during long term operation of the gas turbine. Specifically, the system and method utilizes differences in the modeled and sensed power output of a gas turbine, as well other operating parameters, to generate correction factors with a Kalman filter gain matrix that may be used to adjust the mathematical model of the gas turbine. However, while such a system and method offer substantial advantages, the disclosure does not provide for the mathematical model to be tuned when direct power measurements are not available. For example, most single shaft, combined cycle power generation systems do not include a means for directly measuring the power output of the system.

Accordingly, a system and method that automatically adjusts the mathematical model for a gas turbine without requiring the power output of the gas turbine to be directly measured would be welcomed in the technology.

### BRIEF DESCRIPTION OF THE INVENTION

Aspects and advantages of the invention will be set forth in part in the following description, or may be obvious from the description, or may be learned through practice of the invention.

In one aspect, the present invention resides in a method for simulating operation of a gas turbine. The method may generally include sensing values of a plurality of first operating parameters of a gas turbine, applying the first operating parameters to a model of the gas turbine to generate a plurality of predicted operating parameters, determining difference values between the predicted operating parameters and a corresponding plurality of sensed second operating parameters of the gas turbine, applying an error correction system to the difference values to determine correction factors and adjusting the model of the gas turbine using the correction factors, wherein the predicted operating parameters include at least one predicted combustion product parameter and the sensed second operating parameters include at least one sensed combustion product parameter.

In another aspect, the present invention resides in a method for simulating operation of a gas turbine. The method may generally include determining at least one predicted combustion product parameter using a model of the gas turbine, sensing at least one sensed combustion product parameter, determining a difference value between the at least one predicted combustion product parameter and the at least one sensed combustion product parameter, applying an error correction system to the difference value to determine a correction factor and adjusting the model of the gas turbine using the correction factor.

In a further aspect, the present invention resides in a system for simulating operation of a gas turbine. The system may generally include a plurality of sensors configured to sense values of a plurality of first operating parameters and a plurality of second operating parameters of a gas turbine. The plurality of second operating parameters may generally include at least one sensed combustion product parameter. The system may also include a controller communicatively coupled to the sensors. The controller may be configured to generate a plurality of predicted operating parameters based on the first operating parameters and a plurality of correction factors. The controller may also be configured to determine difference values between the predicted operating parameters and the second operating parameters. Additionally, the controller may be configured to apply en error correction system to the difference values in order to generate the correction factors.

These and other features, aspects and advantages of the present invention will become better understood with reference to the following description and appended claims. The accompanying drawings, which are incorporated in and constitute a part of this specification, illustrate embodiments of the invention and, together with the description, serve to explain the principles of the invention.

### BRIEF DESCRIPTION OF THE DRAWINGS

Various aspects and embodiments of the present invention are defined by the following numbered clauses:
FIG. 1 illustrates a schematic depiction of one embodiment of a combined cycle power generation system;
FIG. 2 illustrates a high level block diagram of one embodiment of a gas turbine, a gas turbine model and a Kalman filter model correction estimator; and
FIG. 3 illustrates a block diagram similar to that show in FIG. 2, but includes a more detailed flow chart of one embodiment of a Kalman filter model correction estimator.

### DETAILED DESCRIPTION OF THE INVENTION

Reference now will be made in detail to embodiments of the invention, one or more examples of which are illustrated in the drawings. Each example is provided by way of explanation of the invention, not limitation of the invention. In fact, it will be apparent to those skilled in the art that various modifications and variations can be made in the present invention without departing from the scope or spirit of the invention. For instance, features illustrated or described as part of one embodiment can be used with another embodiment to yield a still further embodiment. Thus, it is intended that the present invention covers such modifications and variations as come within the scope of the appended claims and their equivalents.

In general, the present subject matter discloses a gas turbine control system and method that employs an adaptive gas turbine model to estimate operating parameters of an operating gas turbine. In particular, the gas turbine model may be configured to estimate operational parameters of the gas turbine that are not directly measured or sensed by sensors for use in control algorithms. In addition, the gas turbine model may be configured to estimate operational parameters of the gas turbine that are directly measured or sensed, which may then be compared to the corresponding measured or sensed values of such parameters. In accordance with disclosure provided herein, the comparison of such estimated and actual parameters may then be used to automatically tune the model as the gas turbine continues to operate.

For example, in several embodiments, the gas turbine model may receive measured operating conditions as input parameters (e.g., ambient pressure, ambient temperature, inlet pressure differential, exhaust pressure differential, ambient specific humidity, compressor inlet temperature, inlet guide vane angle, inlet bleed heat flow, fuel flow, fuel temperature, generator speed, stage one nozzle area, generator power factor and/or the like). The gas turbine model may then generate estimated operating parameters for the gas turbine. Specifically, in accordance with aspects of the present subject matter, the model may generate one or more estimated combustion product parameters (e.g., the concentration of oxygen, carbon dioxide, argon, carbon monoxide, nitrogen and/or water present within the hot gas path) together with additional estimated operating parameters (e.g., exhaust gas temperature, compressor discharge pressure, compressor discharge temperature and/or the like). The estimated operating parameters may then be used in conjunction with corresponding measured operating parameters to control the gas turbine. For example, the measured and estimated operating parameters may be input to control schedules to set the gas turbine operating state (e.g., desired turbine exhaust temperature, total combustor fuel flow, fuel split schedules, inlet bleed heat flow and/or the like). In addition, the measured and estimated operational parameters may be used to evaluate the accuracy of the model and/or to tune the model, as will be described below.

By utilizing combustion product parameters together with additional operating parameters, a gas turbine may be controlled and/or the turbine's model may be tuned without requiring direct power measurements. As such, the disclosed system and method may be advantageously used with power generation systems in which direct power measurements are not available and/or are difficult to obtain. For example, in several embodiments, the present subject matter may be used with gas turbines included within combined cycle power generation systems (e.g., single shaft combined cycle systems). However, it should be appreciated that the disclosed system and method may generally be utilized with any suitable power generation systems, including gas turbine systems in which direct power measurements are available (e.g., multiple or single shaft power generation systems that measure power output using a torque meter coupled to the turbine shaft). For instance, combustion product parameters may be utilized together with direct power measurements to further enhance control of a power generation system and/or to improve the accuracy of the gas turbine model.

As will be described below, the gas turbine model may be regularly, automatically and in real-time tuned using a Kalman filter. In general, the Kalman filter may receive inputs signals indicating the differences between measured operating parameters from various sensors and the estimated operating parameters output from the model. The Kalman filter may also receive as an input a Kalman filter gain matrix (KFGM), which generally corresponds to an array of numbers representing the uncertainty weighted sensitivity of the model estimated parameters to changes in model performance multipliers. Specifically, the KFGM may be calculated by an array of mathematical equations. These equations may receive as inputs a model sensitivity matrix (MSM) as well as estimates of the model and measurement uncertainty. The MSM may be calculated on-line in real-time by perturbation and evaluation of the control resident gas turbine model. The Kalman filter may use the supplied inputs to generate performance multipliers that may then be applied to tune the model and increase the accuracy of the estimated gas turbine parameters. For example, the Kalman filter may optimize the multiplier values to minimize the differences between the estimated and measured operating parameters.

By using the Kalman filter, the gas turbine model may be adaptive to changing efficiencies, flow capacities and other parameters of the actual gas turbine. Specifically, the output performance multipliers generated by the Kalman filter adapt the model to better match the measured parameters of the gas turbine. In addition, the Kalman filter tunes the model to, for example, account for deterioration of component efficiencies, dilution flows and changes in air-flow capacities of the gas turbine that occur during extended operation.

It should be appreciated that, since the MSM and KFGM are calculated on-line and in real-time, the Kalman filter structure may also be able to adapt to changes in the number of available sensors and type of measured output parameters available to compare to the estimated output parameters of the model. For example, when an operating parameter of the gas turbine is no longer being measured, such as due to a sensor failure, the Kalman filter structure may be modified to account for the loss of the measured parameter, and, thus, may continue to generate performance multipliers based on the remaining measured conditions of the gas turbine.

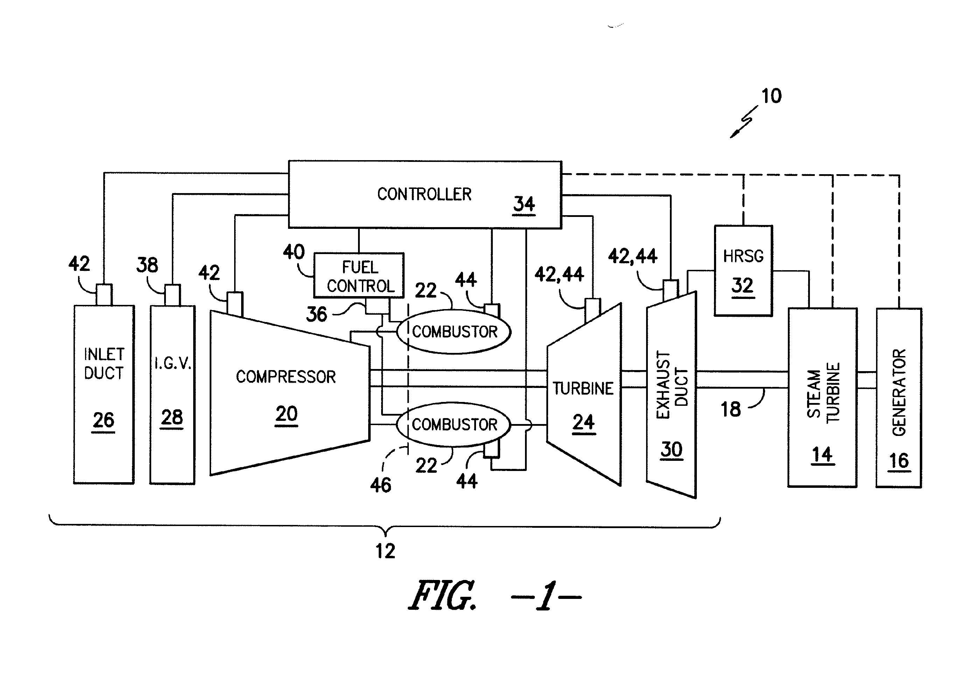

Referring now to the drawings, FIG. 1 illustrates a simplified, schematic depiction of one embodiment of a combined cycle power generation system 10. In general, the system 10 may include a gas turbine 12 and a steam turbine 14 configured to drive a generator 16 (or other load). Specifically, as shown in FIG. 1, the gas turbine 12, steam turbine 14 and generator 16 may be arranged in tandem along a single drive shaft 18. However, in alternative embodiments, the system 10 may have a multi-shaft configuration, wherein the gas turbine 12 and the steam turbine 14 may be coupled to separate shafts in order to drive separate loads (e.g., separate generators 16). It should be appreciated that, although the system 10 is shown as including a single gas turbine 12 and a single steam turbine 14, the combined cycle power generation system 10 may generally include any number of gas turbines 12 and/or steam turbines 14.

In general, the gas turbine 12 may include a compressor 20, one or more combustors 22 and a turbine 24 drivingly coupled to the compressor 20. During operation of the gas turbine 12, the compressor 20 supplies compressed air to the combustor(s) 22. The compressed air is mixed with fuel and burned within the combustor(s) 22 and hot gases of combustion flow from the combustor(s) 22 to the turbine 24 in order to turn the turbine 24 and generate work, for example, by driving the generator 16.

Additionally, the gas turbine 12 may include an inlet duct 26 configured to feed ambient air and possibly injected water to the compressor 20. The inlet duct 26 may have ducts, filters, screens and/or sound absorbing devices that contribute to a pressure loss of ambient air flowing through the inlet 26 and into one or more inlet guide vanes 28 of the compressor. Moreover, the gas turbine 12 may include an exhaust duct 30 configured to direct combustion gases from the outlet of the turbine 24. The exhaust duct 30 may include sound adsorbing materials and emission control devices that apply a backpressure to the turbine 24. The amount of inlet pressure loss and back pressure may vary over time due to the addition of components to the ducts 26, 30 and/or due to dust and/or dirt clogging the inlet and exhaust ducts 26, 30.

As shown in FIG. 1, the combined cycle power generation system 10 may include a heat recovery stream generator (HRSG) system 32 disposed downstream of the gas turbine 12. As is generally understood, the HRSG system 32 may be configured to receive the heated exhaust gases exiting the turbine 24 through the exhaust duct 30. The exhaust gases directed to the HRSG system 32 may, in turn, be used as a heat source for generating high-pressure, high-temperature steam for driving the steam turbine14. For example, the HRSG system 32 may include high pressure, intermediate pressure, and low pressure evaporators and heaters (not shown) for supplying steam to corresponding high pressure, intermediate pressure and low pressure turbines of the steam turbine 14. Thus, the steam produced by the HRSG system 32 may drive the steam turbine 14 to allow additional work to be extracted in order to drive the generator 16.

Moreover, the combined cycle power generation system 10 may also include a controller 34. In general, the controller 34 may comprise any suitable processing unit (e.g., a computer or other computing device) capable of functioning as described herein. For example, in several embodiments, the controller 34 may comprise a General Electric SPEEDTRONIC Gas Turbine Control System, such as is described in Rowen, W. I., "SPEEDTRONIC Mark V Gas Turbine Control System," GE-3658D, published by GE Industrial & Power Systems of Schenectady, N.Y. It should be appreciated that, although the controller 34 will generally be described herein as controlling the operation of the gas turbine 12, the controller 34 may also be configured to control the operation of any other component of the system 10, such as the steam turbine 14, the generator 16 and/or the HRSG system 32 (as indicated by the dashed lines).

The controller 34 may generally include one or more processors that execute programs, such as computer readable instructions stored in the controller's memory, to control the operation of the gas turbine 12 (and/or any other components of the system 10) using sensor inputs and instructions from human operators. For example, the programs executed by the controller 34 may include scheduling algorithms for regulating fuel flow to the combustor(s) 22. As another example, the commands generated by the controller 34 may cause actuators on the gas turbine to, for example, adjust valves (e.g., actuator 36) between the fuel supply and the combustor(s) 22 that regulate the flow, fuel splits and type of fuel flowing to the combustors 22, adjust the angle of the inlet guide vanes 28 (e.g., by using actuator 38) of the compressor 20 and/or to activate other control settings for the gas turbine 12.

The scheduling algorithms may enable the controller 34 to maintain, for example, the NOx and CO emissions in the turbine exhaust to within certain predefined emission limits, and to maintain the combustor firing temperature to within predefmed temperature limits. Thus, it should be appreciated that the scheduling algorithms may utilize various operating parameters as inputs. The controller 34 may then apply the algorithms to schedule the gas turbine 12 (e.g., to set desired turbine exhaust temperatures and combustor fuel splits) so as to satisfy performance objectives while complying with operability boundaries of the gas turbine 12.

Referring still to FIG. 1, the system 10 also include a fuel control system 40 configured to regulate the fuel flowing from a fuel supply to the combustor(s) 22, the split between the fuel flowing into primary and secondary fuel nozzles and/or the amount of fuel mixed with secondary air flowing into the combustion chamber of the combustor(s) 22. The fuel control system 40 may also be adapted to select the type of fuel for the combustor(s) 22. It should be appreciated that the fuel control system 40 may be configured as a separate unit or may comprise a component of the main turbine controller 34.

Additionally, in several embodiments of the present subject matter, operation of the gas turbine 12 may be monitored by a plurality of sensors 42 detecting various operating parameters of the gas turbine and ambient environment. In many instances, two or more sensors 42 may be utilized to measure the same operating parameters. For example, a plurality of redundant temperature sensors 42 may monitor the ambient air temperature, compressor inlet temperature, compressor discharge temperature, turbine exhaust gas temperature, fuel temperature and/or other temperatures of the fluids flowing through the gas turbine 12. Similarly, a plurality of redundant pressure sensors 42 may monitor ambient air pressure and static and dynamic pressure levels at the compressor inlet and outlet, turbine exhaust and at other locations at which fluids are flowing through the gas turbine 12. Moreover, a plurality of redundant humidity sensors 42 (e.g., wet and dry bulb thermometers) may measure ambient specific humidity within the inlet duct 26 of the compressor 20. Further, a plurality of redundant sensors 42 may also comprise flow sensors (e.g., fuel flow sensors, inlet bleed heat flow sensors and/or the like), speed sensors (e.g., turbine shaft speed sensors), flame detector sensors, valve position sensors, guide vane angle sensors and/or the like that sense various other parameters pertinent to the operation of the gas turbine 12.

In addition, the system 10 may include one or more combustion product sensors 44 for measuring a combustion product parameter of the gas turbine 12. As used herein, the term "combustion product parameter" refers to an item(s) that can be used to define an operating condition of one or more of the elements and/or compounds present within the hot gas path of the gas turbine 12 as a result of the combustion process. For example, in several embodiments, the combustion product parameter may correspond to the concentration of one or more of the elements and/or compounds present within the hot gas path, such as the concentration of oxygen, carbon dioxide, argon, carbon monoxide, nitrogen, water and/or the like at a particular location along the hot gas path. In such embodiments, the combustion product sensor(s) 44 may generally comprise any suitable sensing device(s) configured to measure or otherwise sense the concentration of such elements and/or compounds, such as an oxygen sensor, carbon dioxide sensor, argon sensor, carbon monoxide sensor, nitrogen sensor, water vapor sensor and/or the like.

It should be appreciated that, in order to take measurements of one or more of the combustion product parameters, the combustion product sensors 44 may generally be disposed at any suitable location downstream of a combustion point 46 of the gas turbine 12 (i.e., a specific location within the combustor(s) 22 (e.g., within the combustion chamber of the combustor(s) 22) at which combustion initially occurs). Thus, in several embodiments, the combustion product sensors 44 may be disposed at various locations within the gas turbine 12, such as by being located on or within a portion of the combustor(s) 22 (e.g. on or within the transition piece of the combustor(s) 22), the turbine 24 and/or the exhaust duct 30, and/or at various locations downstream of the gas turbine 12, such as on or within the HRSG system 32.

It should also be appreciated that, as used herein, the term "parameter" refers to an item(s) that may be used to define the operating conditions of the gas turbine 12, such as temperatures, pressures, gas flows, gas concentrations, turbine speeds, humidity and the like at defined locations in the gas turbine 12. Some parameters may be measured (e.g., using sensors 42, 44) and, thus, may be directly known. Other parameters may be estimated using the gas turbine model and, thus, may be indirectly known. The measured and/or estimated parameters may generally be used to represent a given turbine operating state.

Additionally, it should be appreciated that the combined cycle power generation system 10 described above is only provided as one example of an exemplary power generation system with which the present subject matter may be advantageously used. Thus, it should be that the disclosed gas turbine control system need not be limited to any particular type of power generation system.

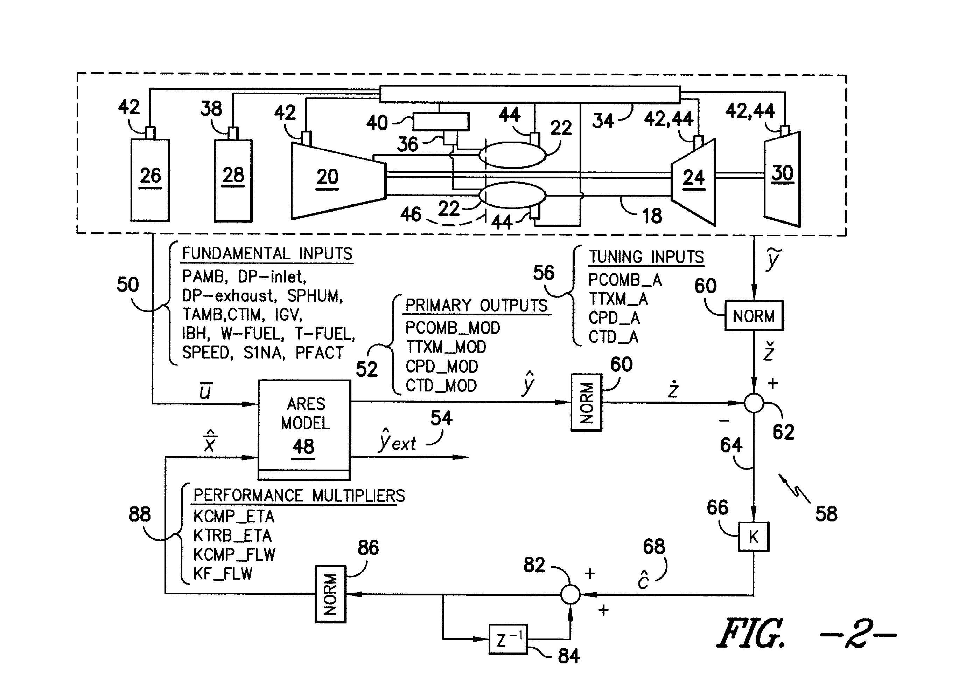

Referring now to FIG. 2, a high-level block diagram of one embodiment of a gas turbine 12 (e.g., the gas turbine 12 described above) and an adaptive real-time engine simulation model 48 (ARES) configured to electronically model, in real-time, several operating parameters of the gas turbine 12 is illustrated in accordance with aspects of the present subject matter. As shown, the gas turbine 12 has several observable parameters that are herein referred to as "fundamental inputs" (u̅) 50. The fundamental inputs 50 may be directly measured by sensors (e.g., sensors 42, 44) and may include (without limitation): ambient conditions, such as the ambient air pressure (PAMB) and ambient air temperature (TAMB), inlet pressure differential (DP-inlet) (i.e., the pressure differential between the ambient air pressure and the pressure of the air exiting the inlet duct 26 and entering the compressor 20), exhaust pressure differential (DP-exhaust) (i.e., the pressure differential between the ambient air pressure and the pressure of the exhaust gases flowing through the exhaust duct 30), specific humidity of the ambient air (SPHUM), compressor inlet temperature (CTIM), angle of the inlet guide vanes 28 (IGV), inlet bleed heat flow (IBH) (i.e., the percentage of the compressor flow redirected to the compressor inlet), flow rate of the fuel supplied to the combustor(s) 22 (W-FUEL), temperature of the fuel (T-FUEL), rotational speed of the turbine shaft (SPEED), effective area of the stage one nozzle of the turbine 24 (S 1NA) and power factor of the generator 16 (PFACT).

The listed fundamental inputs 50 are exemplary and are provided merely to illustrate one example of sensed inputs that may be collected. Thus, it should be appreciated that the specific fundamental inputs 50 of the model 48 are not material to this disclosure and may vary depending on, for example, the type of controller 34 used, the specific model 48 applied and/or the sensors (42, 44) available at a particular gas turbine installation.

It should also be appreciated that the term "fundamental" does not imply or require that each and every one of the measured parameters described above must be input into the gas turbine model 48 disclosed herein or that any such gas turbine model 48 must have these inputs. Thus, the fundamental inputs 50 may only include some of the measured parameters described above and/or may include other measured operating parameters of the gas turbine 12. The term fundamental inputs 50 merely indicates that, for the particular embodiment of the model 48 disclosed herein, these inputs may be taken from measurements of actual turbine conditions and may be applied as inputs to the model 48.

As shown in FIG. 2, the fundamental inputs 50 may be input into the model 48 and may be applied by the model 48 to generate output values (ŷ and ŷₑₓₜ) 52, 54 corresponding to predicted operating parameters of the gas turbine 12. Specifically, the output values may include primary modeled outputs (ŷ) 52 that may be compared to corresponding measured operating parameters (ỹ) 56 (i.e., tuning inputs) of the gas turbine 12. In addition, the modeled output values may include extended modeled outputs (ŷₑₓₜ) 54 that correspond to predicted gas turbine parameters (e.g., desired fuel flow rate, power output and the like) that are not directly measured. The extended modeled outputs 54 may be used by the controller 34 to operate and/or control the gas turbine 12, such as by applying the desired fuel flow rate to control the actual fuel flow rate to the combustor(s) 22.

To ensure that the modeled outputs (ŷ and ŷₑₓₜ) 52, 54 accurately predict the operating parameters of the gas turbine 12, the primary modeled outputs 52 and their corresponding tuning inputs 56 may be applied to an error correction system 58 configured to automatically and regularly tune the model 48. The modeled outputs 52, 54 may then be used for controlling the gas turbine 12, scheduling maintenance and/or predicting the performance of the gas turbine 12.

As shown in the illustrated embodiment, the primary modeled outputs 52 may include, but are not limited to, a modeled combustion product parameter of the gas turbine 12 (PCOMB_MOD) (e.g., a modeled concentration of oxygen, carbon dioxide, argon, carbon monoxide, nitrogen, and/or water within the hot gas path), a modeled turbine exhaust temperature (TTXM_MOD), a modeled compressor discharge pressure (CPD_MOD) and a modeled compressor discharge temperature (CTD_MOD). However, in alternative embodiments, it should be appreciated that the primary modeled outputs 52 may include the modeled combustion product parameter (PCOMB_MOD) and any other suitable number and/or combination of operating parameters that may be both predicted by the model 48 and measured using one or more sensors disposed on or within the gas turbine 12. It should also be appreciated that the primary modeled outputs 52 may vary during operation of the gas turbine 12 if, for example, a sensor fails and the tuning input 56 corresponding to the primary modeled output 52 is no longer available for comparison.

As indicated above, each of the primary modeled outputs 52 may correspond to a measured or sensed operating parameter (ỹ) 54 (i.e., a tuning input) of the gas turbine 12. For example, in the illustrated embodiment, the tuning inputs 56 include an actual combustion product parameter (PCOMB_A) (e.g. a measured concentration of oxygen, carbon dioxide, argon, carbon monoxide, nitrogen, and/or water within the hot gas path), an actual turbine exhaust temperature (TTXM_A), an actual compressor discharge pressure (CPD_A) and an actual compressor discharge temperature (CTD_A). Each of these tuning inputs 56 may be based on output signals of sensors (e.g., sensors 42, 44) monitoring the corresponding actual parameter of the gas turbine 12. As indicated above, multiple redundant sensors may observe each of the measured parameters. Additionally, it should be appreciated that tuning inputs 56 may vary from gas turbine to gas turbine. Thus, the tuning inputs 56 may be selected based on, for example, the type of controller 34 used, the specific model 48 applied and/or the sensors (42, 44) available at a particular gas turbine installation.

It should also be appreciated that the model 48 may generally comprise a computer implemented, mathematical model of the gas turbine 12. For example, the model 48 may comprise an arrangement of mathematical representations of the primary and extended modeled outputs 52, 54, with each of these representations relying on input values (e.g., the fundamental inputs 32) to generate an estimated value of one or more of the modeled outputs 38, 40. Specifically, in several embodiments, the model 48 may comprise a physics-based aero-thermodynamic computer model of the gas turbine 12, a regression-fit model of the gas turbine 12, neural-net model of the gas turbine 12, or any other suitable mathematical model of the gas turbine 12. It should also be appreciated that the development of such a model 48 is well within the purview of one of ordinary skill in the art and, thus, need not be described herein.

Referring still to FIG. 2, as indicated above, the primary modeled outputs 52 may be compared to the tuning inputs 56 in order to tune the model 48. Specifically, the primary modeled outputs 52 and tuning inputs 56 may be normalized 46 to generate normalized modeled outputs (ż) and normalized tuning outputs ( 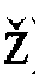 ). Each corresponding pair of normalized outputs (ż, 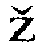 ) may then be compared 62 (e.g., PCOMB_MOD may be compared to PCOMB_A), to generate a difference signal (Δ(ż, 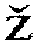 )) 64, such as (Δ(PCOMB_MOD, PCOMB_A)). The difference signal 64 may generally indicate an error of the modeled output parameter 52 with respect to the tuning input 56.

It should be appreciated that, in several embodiments, there may be at least one difference signal 64 corresponding to each of the primary modeled outputs 52 and/or there may be a difference signal 64 corresponding to each of the redundant sensors measuring a particular parameter of the tuning inputs 56. Additionally, it should be appreciated that at least one tuning input 52 may be necessary for each primary modeled output 52 to generate a difference signal 64. Thus, if one or more of the tuning inputs 52 is not available (e.g., due to a failed sensor) the corresponding difference signals 50 will may be generated, but the error correction system 58 may still operate to tune the model 48.

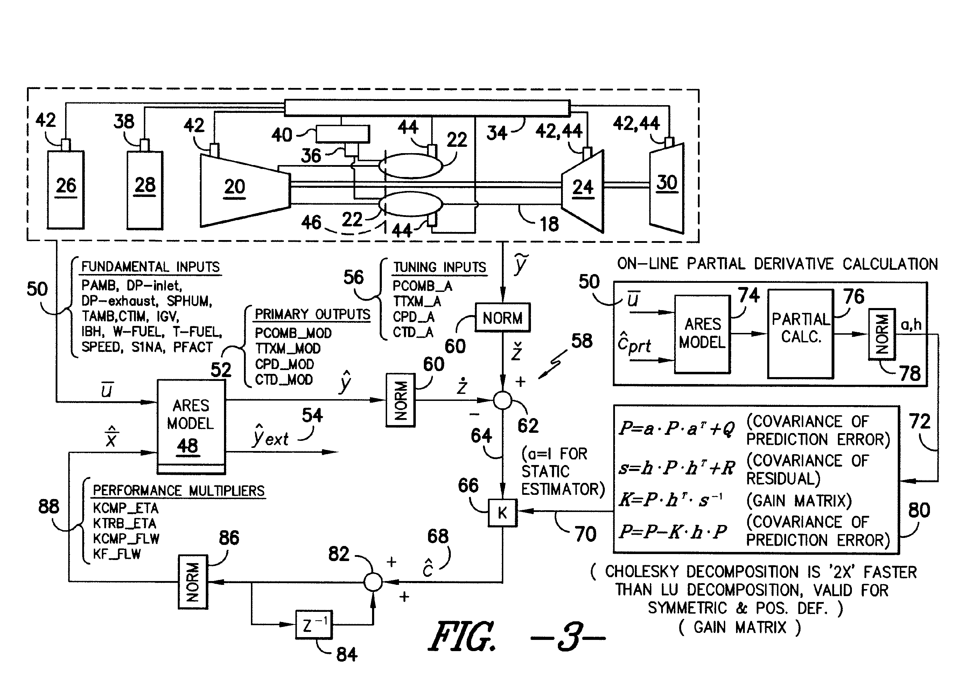

Additionally, a Kalman filter gain matrix (KFGM-K) 66 may receive as an input the difference signals 64 in order to generate normalized correction factor adjustments (ĉ) 68 that may be used to tune the gas turbine model 48. As shown in FIG. 3, the KFGM 66 may apply tuning factors 70 to adjust the difference signals 64 and generate the normalized correction factors 68. In one embodiment, a relatively large number of difference signals 64 (e.g., redundant sensor outputs for each tuning input 54) may enable the KFGM 66 to generate normalized correction factors 68 that may be used to accurately tune the model 48 and ensure that the model 48 generates accurate output values 52, 54.

It should be appreciated that the loss of difference signals 64 may reduce (but not eliminate) the ability of the KFGM 66 to tune the model 48. Specifically, the adaptive ability of the KFGM 66 may enable it to continue to tune the model 48 with a reduced set of difference signals 64. To automatically tune the model 48 when one or more of the difference signals 64 is not available, the KFGM 66 may be modified to account for the loss of a difference signal(s) 64. Accordingly, the gas turbine 12 can continue to operate and be automatically tuned even when sensors fail and tuning input data regarding observable operating parameters is not available.

Referring now to FIG. 3, one embodiment of the mechanism by which the KFGM 66 may be created is illustrated in accordance with aspects of the present subject matter. As shown, a model sensitivity matrix (MSM) (a, h) 72 may be determined by applying a series of inputs, such as fundamental inputs 50 and a series of perturbated performance multipliers (ĉₚᵣₜ) (e.g., perturbated corrected and normalized difference signals 64) to a gas turbine model 74 (e.g., the model 48). The sensitivity of the primary outputs of the model 74 may be determined by a partial derivative analysis 76. Additionally, the sensitivity values may be normalized 78 to form the MSM (a, h) 72. The MSM 72 may be applied to an on-line filter gain calculation 80 (e.g., Kalman filter equations) to determine a matrix of optimal tuning factors 70 (e.g., gain values) that may be applied to the difference signals 64 corresponding to the differences between the measured tuning inputs 56 and the corresponding values 52 predicted by the model 48.

The Kalman filter equations used for the on-line filter gain calculation 80 are shown in FIG. 3. The use of such equations are well known to persons of ordinary skill in the art as an optimal recursive data processing algorithm.

As shown in FIG. 3, the KFGM 66 may receive one or more tuning factors 70 that may be applied to the difference signals 64 to generate normalized correction factor adjustments 68. The normalized correction factors 68 may then be summed 82 with the prior normalized correction factor (Z⁻¹) 84 to average out the differences between the current and prior correction factors 68, 84. The averaged correction factor may then be un-normalized 86 to produce performance multipliers 88 (also un-normalized correction factors) that may include, for example, component efficiencies, such as a compressor efficiency factor (KCMP_ETA) and a turbine efficiency factor (KTRB_ETA), and flow capacities, such as a compressor flow factor (KCMP_FLW) and a heat consumption factor (KF_FLW) (e.g., the ratio of the predicted heat consumption to the actual heat consumption). The un-normalized correction factors 88 may then be applied to the gas turbine model 48 as, for example, multipliers that may be applied to the equations and/or algorithms that model the gas turbine 12 and generate the modeled outputs 52, 54. Specifically, the un-normalized correction factors 88 may tune the model 48 by adjusting the equations and/or algorithms so that they generate modeled outputs 52, 54 that accurately represent the actual operation of the gas turbine 12. The modeled outputs 52, 54 may then be applied to determine fuel and air flow to the gas turbine 12, to determine other control inputs to the gas turbine 12, to determine the power output of the gas turbine 12 and/or to determine any other operating parameters of the gas turbine 12.

The technical effect of the present matter is improved control, performance and/or operation of a gas turbine. In particular, by tuning the gas turbine model 48 on-line and in real-time, the control, performance and/or operation of a gas turbine may be enhanced.

This written description uses examples to disclose the invention, including the best mode, and also to enable any person skilled in the art to practice the invention, including making and using any devices or systems and performing any incorporated methods. The patentable scope of the invention is defined by the claims, and may include other examples that occur to those skilled in the art. Such other examples are intended to be within the scope of the claims if they include structural elements that do not differ from the literal language of the claims, or if they include equivalent structural elements with insubstantial differences from the literal languages of the claims.

## Claims

1. A method for simulating operation of a gas turbine (12), the method comprising:
sensing values of a plurality of first operating parameters of a gas turbine (12);
applying the sensed values of the plurality of first operating parameters to a model (48) of the gas turbine (12) to generate a plurality of predicted operating parameters, the plurality of predicted operating parameters including at least one predicted combustion product parameter;
determining difference values between the plurality of predicted operating parameters and a corresponding plurality of sensed second operating parameters of the gas turbine, the plurality of sensed second operating parameters including at least one sensed combustion product parameter;
applying an error correction system (62) to the difference values to determine correction factors (68); and
adjusting the model (48) of the gas turbine (12) using the correction factors (68).

2. The method of claim 1, wherein the at least one predicted combustion product parameter and the at least one sensed combustion product parameter each comprise at least one of oxygen concentration, carbon dioxide concentration, argon concentration, carbon monoxide concentration, nitrogen concentration and water concentration within the gas turbine (12).

3. The method of claim 1 or 2, further comprising sensing values of the plurality of sensed second operating parameters.

4. The method of claim 3, wherein sensing values of the plurality of sensed second operating parameters comprises sensing the at least one sensed combustion product parameter using at least one combustion product sensor (42,44).

5. The method of claim 4, wherein the at least one combustion product sensor (42,44) is disposed downstream of a combustion point of the gas turbine (12).

6. The method of claim 4 or 5, wherein the at least one combustion product sensor (42,44) comprises at least one of an oxygen sensor, a carbon dioxide sensor, an argon sensor, a carbon monoxide sensor, a nitrogen sensor and a water vapor sensor.

7. The method of any of claims 3 to 6, wherein sensing values of the plurality sensed second operating parameters comprises sensing the at least one sensed combustion product parameter and at least one of turbine exhaust temperature, compressor discharge pressure and compressor discharge temperature.

8. The method of any preceding claim 1, wherein determining difference values between the plurality of predicted operating parameters and a corresponding plurality of sensed second operating parameters of the gas turbine (12) comprises determining a difference value between the at least one predicted combustion product parameter and the at least one sensed combustion product parameter.

9. The method of any preceding claim, wherein sensing values of a plurality of first operating parameters of a gas turbine (12) comprises sensing at least one of ambient pressure, inlet pressure differential, exhaust pressure differential, ambient specific humidity, ambient temperature, compressor inlet temperature, inlet guide vane angle, inlet bleed heat flow, fuel flow, fuel temperature, generator speed, stage one nozzle area and generator power factor (68).

10. The method of claim 1, wherein applying an error correction system (58) to the difference values to determine correction factor (68) comprises applying a Kalman filter gain matrix to pertrubated values of the difference values to determine the correction factors (68).

11. A system (10) for simulating a gas turbine (12), the system comprising:
a plurality of sensors (42,44) configured to sense values of a plurality of first operating parameters and a plurality of second operating parameters of a gas turbine (12), the plurality of second operating parameters including at least one sensed combustion product parameter;
a controller (34) communicatively coupled to the plurality of sensors (42,44), the controller (34) being configured to generate a plurality of predicted operating parameters based on the sensed values of the plurality of first operating parameters and a plurality of correction factors (68), the controller (34) being further configured to determine difference values between the plurality of predicted operating parameters and the sensed values of the plurality of second operating parameters, the controller (34) being further configured to apply an error correction system (58) to the difference values in order to generate the plurality of correction factors (68).

12. The system of claim 11, wherein the plurality of sensors (42,44) comprises at least one combustion product sensor, the at least one combustion product sensor being disposed downstream of a combustion point of the gas turbine.

13. The system of claim 12, wherein the at least one combustion product sensor comprises at least one of an oxygen sensor, a carbon dioxide sensor, an argon sensor, a carbon monoxide sensor, a nitrogen sensor and a water vapor sensor.

14. The system of any of claims 11 to 13, wherein the plurality of predicted operating parameters comprise at least one predicted combustion product parameter; and
wherein the at least one predicted combustion product parameter and the at least one sensed combustion product parameter each comprise at least one of oxygen concentration, carbon dioxide concentration, argon concentration, carbon monoxide concentration, nitrogen concentration and water concentration within the gas turbine.
